Europäisches Patentamt

European Patent Office

Office européen des brevets

(11) Numéro de publication: **0 002 247**
**A1**

## (12) DEMANDE DE BREVET EUROPEEN

(21) Numéro de dépôt: **78101468.3**

(22) Date de dépôt: **28.11.78**

(51) Int. Cl.²: **H 04 M 11/06**
H 04 L 27/30, G 06 F 3/02

(30) Priorité: **06.12.77 FR 7736715**
**06.12.77 FR 7736716**

(43) Date de publication de la demande:
**13.06.79 Bulletin 79 12**

(84) Etats contractants désignés:
**BE CH DE FR GB NL SE**

(71) Demandeur: **S.A. dite: COMPAGNIE INDUSTRIELLE DES TELECOMMUNICATIONS CIT-ALCATEL**
**12, rue de la Baume**
**F-75008 Paris(FR)**

(72) Inventeur: **Picart, Alain**
**Résidence Val La Croix Bat.B Esc.3**
**F-91320 Wissous(FR)**

(74) Mandataire: **Weinmiller, Jürgen et al,**
**Zeppelinstrasse 63**
**D-8000 München 80(DE)**

(54) Dispositif de transmission de caractères applicable à un terminal téléphonique à clavier.

(57) Dispositif de transmission de caractères applicable à un terminal téléphonique à clavier du type à code multifréquence, ledit terminal comportant un circuit d'émission et un circuit de réception des signaux du code multifréquence, un dispositif d'affichage (VS) des caractères utilisables en émission et en réception, et un dispositif d'extension de code (TEC) permettant d'associer à chaque touche plusieurs caractères, le circuit d'émission émettant un signal multifréquence de code de base sélectionné par l'actionnement d'une touche du clavier et un signal multifréquence sélectionné à l'aide du dispositif d'extension de code (TEC).

FIG.4

EP 0 002 247 A1

## Dispositif de transmission de caractères applicable a un terminal téléphonique à clavier

L'invention a pour objet un dispositif de transmission de caractères applicable à un terminal téléphonique à clavier notamment du type à code multifréquence.

Les postes téléphoniques à clavier sont pourvus de douze touches : dix comportant les chiffres 0 à 9 pour l'émission de la numérotation et deux touches de fonction. Le signal de numérotation en code multifréquence se compose de deux fréquences émises simultanément lorsqu'on presse une touche du clavier.

Une émission alphanumérique peut être effectuée à l'aide d'un poste téléphonique à clavier en sensibilisant le récepteur par un préfixe spécial spécifiant l'identité du caractère à émettre, et en élargissant le code des combinaisons de fréquence par la frappe successive d'une même touche ou de deux touches dudit clavier, selon que l'on veut émettre un chiffre ou un caractère (lettre ou signe), soit encore en combinant les deux moyens précédents. L'utilisation du préfixe est contraignante car cela oblige à numéroter plusieurs chiffres avant de pouvoir émettre le caractère proprement dit. Ce procédé d'émission alphanumérique ne permet qu'une extension réduite des combinaisons de code. De plus, le fait que les chiffres seuls sont disposés sur les touches du clavier et que les lettres et (ou) les signes sont disposés sur l'environnement des touches, complique la lecture du clavier, l'opérateur devant être particulièrement bien entraîné pour effectuer rapidement et sans faute les manoeuvres de frappe nécessitées par une émission alphanumérique.

Le but de l'invention est de supprimer ces inconvénients moyennant des modifications mineures apportées au poste téléphonique à clavier actuel afin de permettre une utilisation pratique de celui-ci, aussi bien en exploitation téléphonique classique que comme terminal à mode conversationnel après connexion à un ordinateur, ladite connexion pouvant être réalisée par l'intermédiaire

- 2 -　　　0002247

d'un autocommutateur téléphonique public ou privé.

L'invention a pour objet un dispositif de transmission de caractères applicable à un terminal téléphonique à clavier du type à code multifréquence, ledit terminal comportant un circuit d'émission et un circuit de réception des signaux du code multifréquence, un dispositif d'affichage des caractères utilisables en émission et en réception, et un dispositif d'extension de code permettant d'associer à chaque touche plusieurs caractères, le circuit d'émission émettant un signal multifréquence de code de base sélectionné par l'actionnement d'une touche du clavier et un signal multifréquence sélectionné à l'aide du dispositif d'extension de code, caractérisé par le fait que ledit circuit d'émission comporte des premiers moyens d'enregistrement et de codage du numéro d'identification du signal du code de base correspondant à la touche actionnée, des seconds moyens d'enregistrement et de codage du numéro d'identification du signal d'extension de code, un émetteur multifréquence relié à la ligne téléphonique, un aiguilleur dont les entrées sont reliées à la sortie des premiers et des seconds moyens d'enregistrement et de codage, et un circuit séquentiel de commande de l'aiguilleur, et en ce que ledit circuit de réception comporte un circuit de détection et de codage de signaux multifréquences reliés à la ligne téléphonique, une mémoire contenant tous les caractères utilisés par le dispositif de transmission, la sortie de la mémoire étant reliée au dispositif d'affichage des caractères, des moyens d'enregistrement contrôlés par un circuit de temporisation et reliés à la sortie du circuit de détection et de codage pour mémoriser successivement le numéro d'identification du signal du code de base et le numéro d'identification du signal d'extension de code, lesdits numéros d'identification étant combinés pour permettre l'adressage de ladite mémoire.

Suivant une autre caractéristique de l'invention, le dispositif d'extension de code peut comporter des touches affectées chacune à l'émission d'un signal d'extension de code, les touches d'émission du code de base ayant dans ce cas au niveau de chaque caractère des moyens de repérage de la touche d'extension de code à utiliser pour émettre ledit caractère.

0002247

Suivant une autre caractéristique de l'invention, le dispositif d'extension de code peut comporter un compteur piloté par une horloge permettant l'affichage successif de tous les caractères correspondant à une touche du code de base actionnée par l'opérateur. Dans ce cas l'opérateur devra relâcher la touche au moment où apparaît sur les moyens d'affichage le caractère qu'il désire émettre qui sera pris en compte à ce moment par le dispositif d'émission.

Deux formes de réalisation non limitatives de l'invention sont décrites ci-après à titre d'exemple à l'aide des figures suivantes :

- la figure 1 représente une première forme de réalisation de terminal à clavier selon l'invention

- la figure 2 représente un schéma de la partie émettrice du système de transmission selon la figure 1

- la figure 3 représente un schéma de la partie réceptrice du système de transmission selon la figure 1

- la figure 4 représente une deuxième forme de réalisation de terminal à clavier selon l'invention,

- la figure 5 représente un schéma de la partie émettrice du dispositif de transmission selon la figure 4,

- la figure 6 représente un schéma de la partie réceptrice du dispositif de transmission selon la figure 4.

Le signal de numérotation d'un poste téléphonique à clavier à code multifréquence se compose de deux fréquences sélectionnées chacune parmi quatre, lesdites fréquences étant émises simultanément lorsqu'on presse une touche du clavier. Ce type de code multifréquence préconisé par le CCITT (Avis Q23) pour les fréquences d'émission des postes téléphoniques à clavier est dit : 2 fois un parmi quatre « 2(1/4)». Le tableau 1 représenté ci-après donne les combinaisons de fréquences du code multifréquence 2(1/4) en fonction des chiffres à émettre.

Le chiffre 1 par exemple est émis par la combinaison des fréquences A1 = 697 hertz et B1 = 1209 hertz.

|  |  | B1 1209 | B2 1336 | B3 1477 | B4 1633 |
|---|---|---|---|---|---|
| A1 | 697 | 1 | 2 | 3 | a |
| A2 | 770 | 4 | 5 | 6 | b |
| A3 | 852 | 7 | 8 | 9 | c |
| A4 | 941 | ✳ | 0 | ≠ | d |

tableau 1

Les caractères cernés par un trait gras correspondent à ceux des touches du clavier d'un poste téléphonique actuel. Les touches du clavier marquées ✳ et ≠ étaient utilisées jusqu'à présent pour réaliser des combinaisons limitées d'extension de code et des fonctions de commande et de contrôle. Les cases a, b, c, d, du tableau 1 désignent des combinaisons de fréquence de réserve.

En utilisant lesdites combinaisons de réserve, on peut réaliser quatre extensions de combinaisons de code de douze caractères chacune, soit quarante-huit caractères, lesdites extensions étant respectivement désignées E1, E2, E3, E4. Le tableau 2 donne un exemple des caractères pouvant être ainsi identifiés par des extensions de code. Les extensions 1 à 4 (E1 à E4) réalisées par les combinaisons de fréquences A1-B4 à A4-B4 permettent de sélectionner respectivement les colonnes par une combinaison du code de base et une combinaison d'extension.

tableau 2

| | | | | Code (2 1/4) | |
|---|---|---|---|---|---|
| ? | : | / | 1 | A1 | B1 |
| C | B | A | 2 | A1 | B2 |
| F | E | D | 3 | A1 | B3 |
| I | H | G | 4 | A2 | B1 |
| L | K | J | 5 | A2 | B2 |
| O | N | M | 6 | A2 | B3 |
| R | Q | P | 7 | A3 | B1 |
| U | T | S | 8 | A3 | B2 |
| X | W | V | 9 | A3 | B3 |
| – | + | = | * | A4 | B1 |
| ^ | Z | Y | 0 | A4 | B2 |
| , | . | x | # | A4 | B3 |

Code de base

| | | | | | |
|---|---|---|---|---|---|
| | | | E1 | A1 | B4 |
| | | | E2 | A2 | B4 |
| | | E3 | | A3 | B4 |
| | E4 | | | A4 | B4 |

Extensions

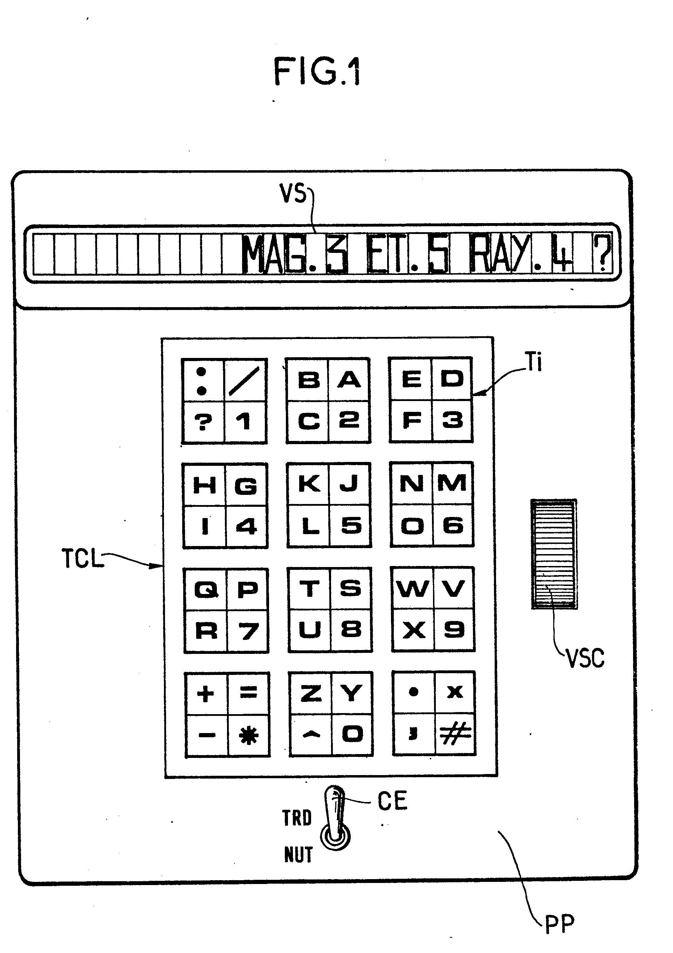

Le pupitre PP du terminal téléphonique selon l'invention est représenté figure 1. Il comporte les 12 touches TCL d'un poste téléphonique à clavier classique.

Les touches TCL sont divisées chacune en quatre cases, chaque case comportant inscrits un chiffre, une lettre ou un symbole.

Le pupitre PP comporte également un panneau de visualisation VS sur lequel viennent s'afficher les caractères frappés au clavier. Ledit panneau affiche, à titre d'exemple, une interrogation alphanumérique concernant le stockage de fournitures en rayon 4 situé au 5ème étage d'un magasin N° 3. Le pupitre PP comporte également une roue moletée VSC permettant de régler la vitesse de succession des caractères des touches actionnées du clavier.

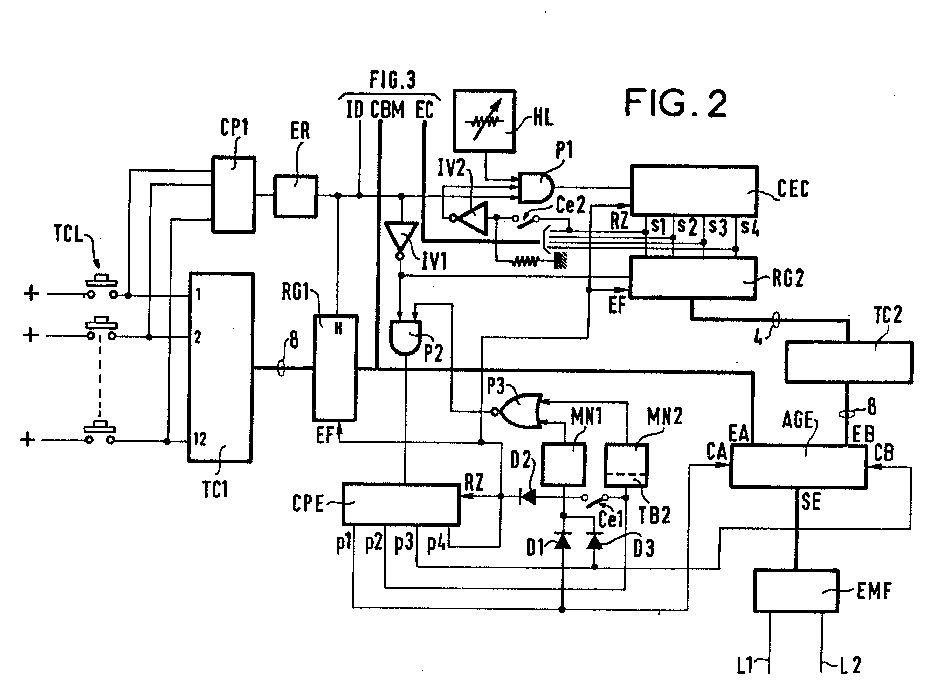

Dans le dispositif d'émission représenté figure 2, les touches TCL du clavier sont répertoriées selon l'ordre décimal 1, 2, ..... 12, la touche marquée du chiffre 1 correspondant par exemple à la première touche, celle marquée du chiffre 2 à la seconde touche,.. ...., celle marquée du symbole # correspondant à

0002247

la douzième touche. La frappe desdites touches permet de connecter des polarités positives sur les entrées d'un transcodeur TC1 du code décimal en code multifréquence 2 1/4. Les entrées dudit transcodeur sont reliées aux entrées d'un circuit CP1 à fonction OU, lequel attaque l'entrée H d'horloge d'un registre RG1 via un éliminateur de rebondissements ER1. Les sorties du transcodeur TC1 sont reliées aux entrées du registre RG1 et les sorties homologues dudit registre sont reliées aux entrées EA d'un aiguilleur d'émission AGE dont la sortie SE attaque un émetteur multifréquence EMF, ce dernier étant raccordé en sortie à la ligne téléphonique L1, L2.

La sortie de l'éliminateur de rebondissements ER1 contrôle l'avancement d'un compteur d'extensions de code CEC via une porte ET P1 qui reçoit les signaux d'une horloge HL à fréquence réglable. Les sorties s1 à s4 des pas 1 à 4 dudit compteur sont reliées aux entrées de données d'un registre RG2 dont les sorties homologues attaquent un transcodeur TC2 du code décimal en code multifréquence. Les sorties dudit transcodeur sont reliées aux entrées EB de l'aiguilleur AGE.

Le circuit OU CP1 commande également par l'intermédiaire de l'éliminateur de rebondissements et d'un inverseur IV1, l'entrée H d'hologe du registre RG2. La sortie dudit inverseur est reliée à l'entrée d'un compteur de phases d'émission CPE via une porte ET P2, elle-même contrôlée par les sorties de deux bascules monostables MN1 et MN2 via une porte NON-OU P3.

Le compteur CPE comporte cinq pas p0 à p4 dont le pas 0, qui est le pas de repos, n'est pas représenté. La sortie de pas 1, p1, est reliée, d'une part à une entrée CA de commande d'aiguillage de l'entrée EA sur la sortie SE de AGE et, d'autre part, à la bascule monostable MN1 via une diode D1. La sortie de pas 2, p2, du compteur CPE, est reliée, d'une part à l'entrée de la bascule monostable MN2 et, d'autre part, à l'entrée de remise à zéro RZ dudit compteur via un contact de travail ce1 d'une clé CE de commutation d'émission placée sur le pupitre PP, et via une diode D2. La sortie p3 de CPE est reliée à l'entrée CB de AGE et à l'entrée de la bascule monostable MN1 via une diode D3. La sortie p4 de pas 4 est reliée à l'entrée RZ des compteurs CPE et CEC et à l'entrée EF des registres RG1 et RG2. La bascule monostable MN1 effectue une temporisation de plusieurs dizaines de millisecondes avant de commander l'avance du compteur sur le pas suivant ; la temporisation de la bascule MN2 est de l'ordre de quelques millisecondes.

La sortie de l'éliminateur de rebondissements ainsi que les sorties du compteur d'extension de code CEC et du registre RG1 sont dérivées vers le dispositif de réception respectivement par les laisons ID, EC et CBM. La sortie s1 du compteur CEC est reliée à une entrée de la porte P1 via un inverseur IV2 et un contact de travail ce2 de la clé de commutation CE.

Dans le cas de la transmission de données, clé CE en position TRD, le dispositif d'émission fonctionne de la façon suivante. L'opérateur appuie sur la touche comportant le caractère qu'il veut émettre (chiffre, lettre ou signe) et maintient ladite touche enfoncée. Le numéro d'ordre décimal de la touche actionnée est transcodé en code 2 1/4 par le transcodeur TC1, puis enregistré dans le registre RG1 lors du front montant du signal d'état 1 présenté sur son entrée H. La touche du clavier maintenue enfoncée valide la porte P1 et le compteur d'extension de code CEC progresse au rythme des impulsions périodiques (1 hertz par exemple) de l'horloge HL. L'état 1 présenté sur le fil ID inhibe la fonction de décalage dans la logique de visualisation LV du récepteur. Le code de base mémorisé dans le registre RG1 est signifié au récepteur par les liaisons CBM et l'extension de code désignée par le compteur CEC lui est communiquée par les liaisons EC. Au reçu de ces indications le récepteur se positionne de manière que la visualisation affiche successivement les différents caractères inscrits sur la touche maintenue enfoncée du clavier. Tant que ladite touche n'est pas relâchée, ces caractères sont affichés de façon que le caractère suivant remplace le précédent au rythme du compteur CEC, c'est-à-dire toutes les secondes par exemple si l'horloge HL a été ajustée au moyen de la roue moletée VSC pour fonctionner à ce rythme.

Supposons par exemple que l'opérateur veuille émettre la lettre E, pour cela il va enfoncer la touche Ti comportant ladite lettre et verra se succéder sur la visualisation les caractères 3, D et E qui figurent sur ladite touche : dès que le E apparaît sur la visualisation l'opérateur relâche la touche et c'est ce caractère qui va être pris en compte par le dispositif d'émission pour être émis en ligne.

En effet au relâchement de la touche, le circuit OU CP1 présente un état 0 qui verrouille la porte P1 et stoppe le compteur CEC qui transfère le rang de l'extension de code au registre RG2. Le compteur de phases d'émission CPE passe au pas 1, déclenche la temporisation de la bascule MN1 et, durant ladite temporisation (40 millisecondes par exemple), applique sur l'entrée CA de l'aiguilleur AGE un signal de commande d'aiguillage EA-SE de la première combinaison de fréquences codée 2 1/4 qui est ainsi transférée vers l'émetteur multifréquence EMF. En fin de temporisation, MN1 commande la progression du compteur CPE au pas 2. La clé CE étant en position TRD de transmission de données, le contact de travail ce1 est ouvert, interdisant ainsi la remise à zéro du compteur CPE. Dès son passage au pas 2 le compteur CPE excite la bascule monostable MN2, laquelle, trois millisecondes plus tard par exemple, délivre un signal provoquant le passage dudit compteur au pas 3. Le signal en sortie p3 de CPE déclenche la temporisation de MN1 et commande, par l'entrée CB de AGE, l'aiguillage EB-SE et le transfert sur EMF de la seconde combinaison codée 2 1/4 de fréquences. Quarante millisecondes plus tard MN1 commande le passage du compteur CPE sur le pas 4 et le signal en sortie p4 commande la remise à zéro des compteurs CPE et CEC et l'effacement des registres RG1 et RG2. On effectue ainsi l'émission successive en ligne des deux paires de fréquences.

Lorsque l'opérateur veut utiliser son pupitre pour effectuer une numérotation téléphonique classique, il oriente la clé CE en position NUT, ce qui ferme les contacts Ce1 et Ce2. Le contact Ce2 étant fermé, lorsque le compteur CEC passe au pas 1 sa sortie s1 verrouille, via l'inverseur IV2 et le contact Ce2, la porte P1 qui interdit toute nouvelle progression dudit compteur sur les signaux d'horloge tandis que le circuit P2, IV1 commande l'avancement au pas 1 du compteur de phases d'émission CPE. La combinaison codée 2 1/4 provenant de la touche TCL est transmise en ligne comme précédemment, puis, comme le contact Ce1 est établi, le compteur CPE revient à zéro dès son passage au pas 2. Le circuit d'entrée retardateur TB2 interdit le basculement de la bascule monostable MN2 durant la transition pas 2 - pas 0 du compteur. Seule la combinaison du code de base est ainsi transmise en ligne et l'autocommutateur téléphonique l'interprète comme provenant d'une numérotation multifréquence frappée au clavier d'un poste téléphonique.

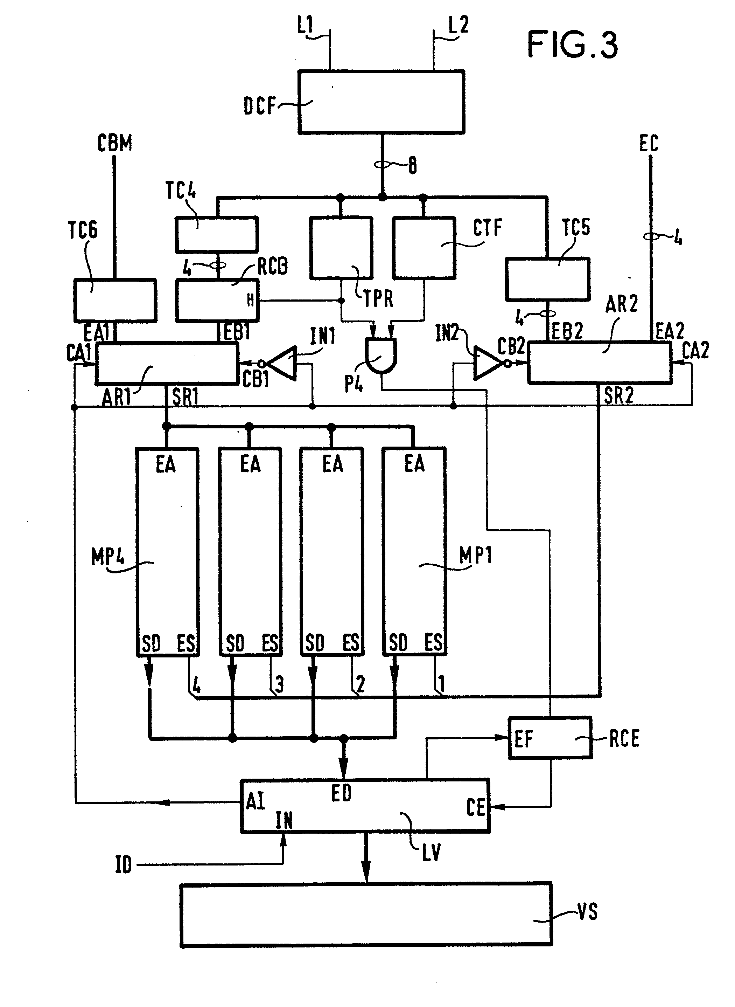

Le dispositif de réception représenté figure 3 comporte en dérivation sur la ligne L1-L2 un détecteur-codeur de fréquences DCF à huit sorties, lequel marque durant chaque réception de combinaisons multifréquences deux des huit sorties correspondant aux fréquences détectées. Les sorties du détecteur-codeur DCF sont reliées en parallèle à un transcodeur 2/8 - binaire TC4 des signaux du code de base, à un transcodeur 2/8 - décimal TC5 des signaux d'extension de code, à un dispositif de contrôle CTF de la réception de deux fréquences parmi deux groupes de quatre fréquences à raison d'une fréquence par groupe, et à un dispositif de temporisation de reconnaissance TPR. La sortie quatre fils du transcodeur TC4 est reliée, via un registre RCB, à l'entrée EB1 d'un aiguilleur de réception AR1. L'entrée EA1 dudit aiguilleur est reliée, via un transcodeur 2/8 - binaire TC6 et une liaison CBM, à la sortie du registre RG1 du dispositif d'émission. La sortie SR1 de l'aiguilleur AR1 est reliée en parallèle aux entrées d'adresse EA de quatre mémoires programmables MP1 à MP4. L'entrée H d'horloge du registre RCB est reliée à la sortie du dispositif de temporisation TPR. La sortie quatre fils du transcodeur 2/8 - décimal TC5 désigne, lorsqu'elle est activée, une extension E1 à E4 du code de base. Ladite sortie est reliée à l'entrée EB2 d'un aiguilleur AR2 dont l'entrée EA2 est reliée à la sortie du compteur CEC par les liaisons EC. La sortie quatre fils SR2 de l'aiguilleur AR2 est reliée aux entrées de sélection ES des mémoires programmables, de sorte que le fil 1 d'identification de l'extension de code E1 est relié à l'entrée de lecture de la mémoire MP1, le fil 2 est relié à l'entrée de lecture de la mémoire MP2, etc.

Les sorties de données SD des mémoires MP sont reliées en parallèle aux entrées de données ED d'une logique de visualisation LV associée à une visualisation VS à décalage, du type calculatrice. Les sorties des dispositifs CTF et TPR commandent, via une porte ET P4 et un registre tampon RCE, l'entrée d'échantillonnage de la logique LV. La logique LV assure l'effacement du registre RCE lorsqu'elle a enregistré les données provenant d'une mémoire lue. La liaison ID aboutissant sur l'entrée IN de la logique de visualisation LV est raccordée à la sortie de l'éliminateur de rebondissements ER du dispositif d'émission ; un signal d'état 1 est présenté sur ladite liaison tant que l'opérateur maintient enfoncée une touche quelconque du clavier, de sorte que ledit signal interdit le décalage du caractère affiché par la visualisation tant que ladite touche n'a pas été relâchée.

La sortie AI de la logique LV est, d'une part reliée directement aux entrées de commande d'aiguillage CA1 et CA2 des aiguilleurs AR1 et AR2 et, d'autre part, à l'entrée CB1 de AR1, via un inverseur IN1, à l'entrée CB2 de AR2 via un inverseur IN2.

Le dispositif de réception associé au terminal et opérant en contrôle local d'émission fonctionne de la façon suivante. L'opérateur voulant par exemple émettre la lettre E appuie sur la touche Ti (figure 1) et maintient son doigt sur ladite touche. Le code de base, mémorisé en code MF 2 1/4 dans le registre RG1 de l'émetteur (figure 2), est reconduit en code binaire sur les entrées EA1 de l'aiguilleur AR1. Les extensions de code successives désignées en code décimal par la progression du compteur CEC de l'émetteur sont présentées sur les entrées EA2 de l'aiguilleur AR2.

En réponse au signal d'inhibition du décalage, la logique LV commande simultanément, par les entrées CA1 et CA2 des aiguilleurs AR1 et AR2, les aiguillages EA1-SR1 et EA2-SR2. Le code de base est ainsi présenté par EA1-SR1 sur les entrées d'adresse EA des mémoires MP1 à MP4 et sélectionne le même niveau desdites mémoires où sont programmés respectivement le caractère 3 dans la mémoire MP1, le caractère D dans la mémoire MP2, ..., le caractère F dans la mémoire MP4 ; ledit niveau correspond à la troisième rangée du tableau 2. Les extensions de code E1 à E4 étant transmises par EA2-SR2 respectivement sur les entrées de sélection des mémoires MP1 à MP4, l'opérateur voit successivement apparaître lesdits caractères sur la visualisation VS, le caractère visualisé suivant se substituant au précédent.Dès que la lettre E à transmettre apparaît sur la visualisation, l'opérateur relâche la touche du clavier, ce qui a pour effet de supprimer le signal d'inhibition du décalage. En réponse, la logique LV supprime l'état 1 en sortie AI et, de ce fait, commande simultanément les aiguillages EB1-SR1 et EB2-SR2. Ainsi, après réception via DCF et TC4 du code de base et enregistrement dudit code en binaire dans le registre RCB, puis, après réception via TC5 de l'extension de code mémorisée dans le registre RG2 (figure 2) au relâchement de la touche, le caractère E transmis au récepteur reste visualisé tant que l'opérateur n'appuie pas sur une autre touche, ledit caractère se décalant sur la visualisation lorsque l'opérateur actionne une autre touche pour sélectionner et émettre un nouveau caractère (ou sur la même touche pour sélectionner et émettre le même caractère une nouvelle fois). On notera que le dispositif de réception au repos a ses aiguilleurs AR1 et AR2 positionnés de manière à opérer les aiguillages respectifs EB1-SR1 et EB2-SR2, ceci afin d'effectuer un affichage direct des caractères qui lui sont transmis d'une station distante.

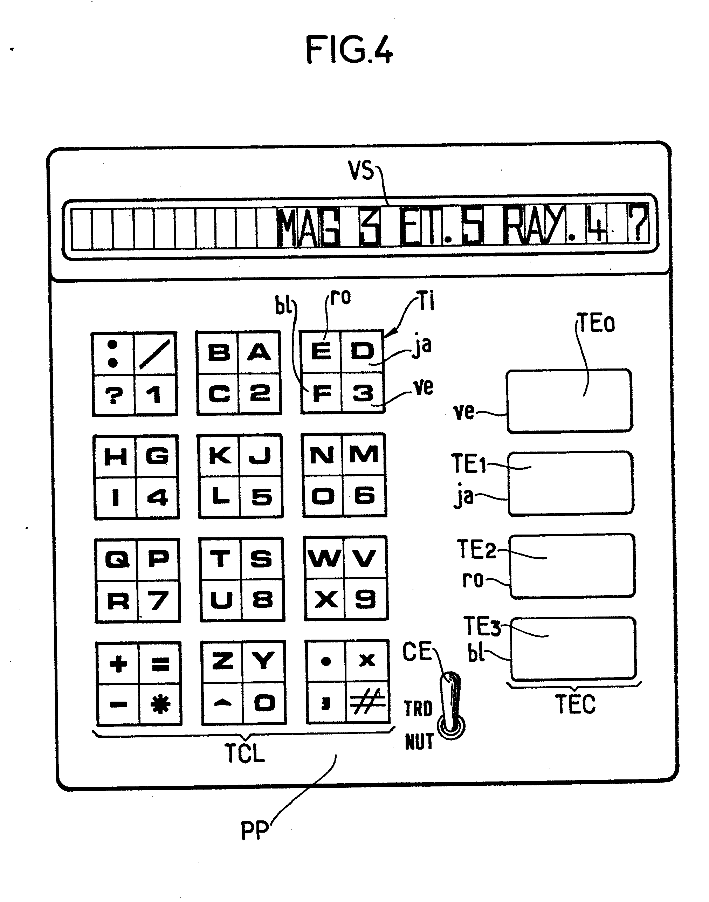

Une seconde forme de réalisation de l'invention est décrite à l'aide des figures 4, 5 et 6.

Le pupitre PP du terminal téléphonique selon l'invention est représenté figure 4. Il comporte, outre les douze touches TCL du clavier, quatre touches d'extension de code TEC, ces dernières étant respectivement désignées par TE0 à TE3.

Les touches TCL sont divisées chacune en quatre cases, chaque case portant un chiffre, une lettre ou un symbole, lesdites cases étant de couleur différente, par exemple verte (ve), jaune (ja), rouge (ro), bleue (bl) et l'ordre des couleurs étant le même pour chaque touche TCL.

Les touches d'extension de code sont également teintées selon les couleurs des touches du clavier mais à raison d'une seule couleur par touche TEC.

Le pupitre PP comporte, en outre, un panneau de visualisation VS sur lequel viennent s'afficher les caractères frappés au clavier. Ledit panneau affiche, à titre d'exemple, une interrogation alphanumérique concernant le stockage de fournitures en rayon 4 situé au cinquième étage d'un magasin N°3.

L'émission d'un caractère est réalisée par la frappe de la touche dont une case comporte ledit caractère, puis par la frappe de la touche d'extension de code de la couleur de ladite case, ainsi l'émission de la lettre E s'obtient en appuyant sur la touche TCL située en haut et à droite puis, la case de ladite lettre étant rouge, en appuyant sur la touche TEC de couleur rouge soit $TE_2$.

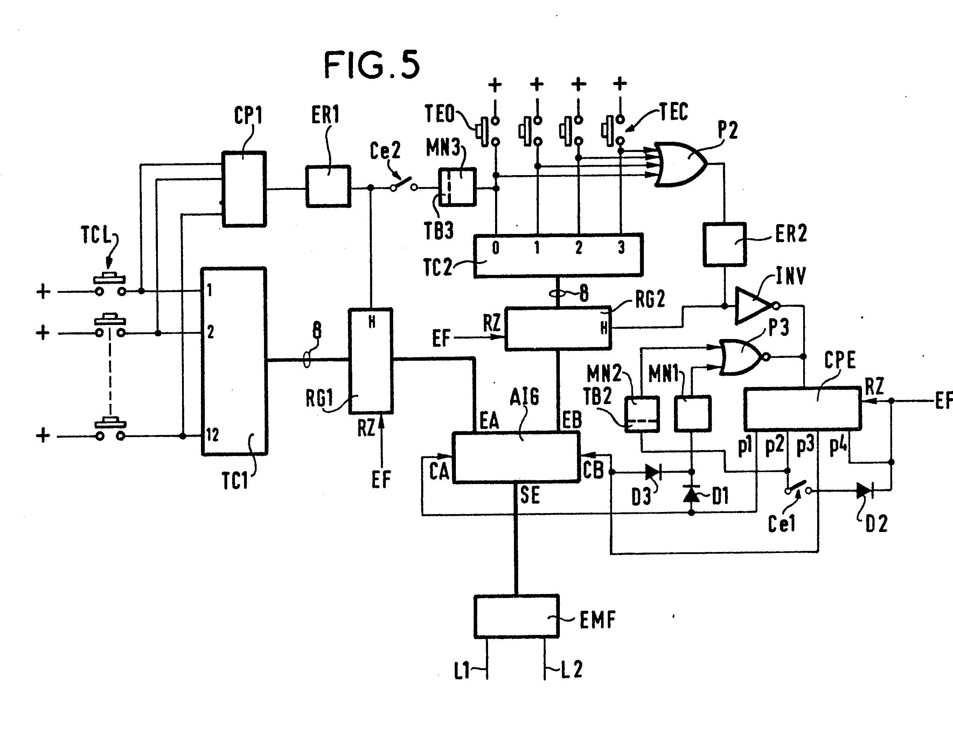

Dans le dispositif d'émission représenté figure 5, les touches TCL du clavier sont répertoriées selon l'ordre décimal 1, 2, ..... 12, la touche marquée du chiffre 1 correspondant par exemple à la première touche, celle marquée du chiffre 2 à la seconde touche, ....., celle marquée du symbole ⌗ correspondant à la douzième touche et réalisant par exemple la fonction "espace". La frappe desdites touches permet de connecter des polarités positives sur les entrées d'un transcodeur TC1 du code décimal en code multifréquence 2 1/4. Les entrées dudit transcodeur sont reliées aux entrées d'un circuit CP1 à fonction OU, lequel attaque l'entrée H d'horloge d'un registre RG1 via un éliminateur de rebondissements ER1. Les sorties du transcodeur TC1 sont reliées aux entrées du registre RG1 et les sorties homologues dudit registre sont reliées aux entrées EA d'un aiguilleur AIG dont la sortie SE attaque un émetteur multifréquence EMF, ce dernier étant raccordé en sortie à la ligne téléphonique L1, L2.

Les touches d'extension de code TEC sont répertoriées TE0 à TE3 et permettent le marquage de polarités positives sur les entrées 0 à 3 d'un transcodeur TC2 du code décimal en code multifréquence 2 1/4. Les entrées dudit transcodeur sont reliées à une porte OU P2 dont la sortie est reliée à l'entrée H d'horloge d'un registre à décalage RG2 via un éliminateur de rebondissements ER2.

Les sorties du transcodeur TC2 sont reliées aux entrées du registre RG2 et les sorties homologues dudit registre commandent les entrées EB de l'aiguilleur AIG. La sortie de l'éliminateur de rebondissements ER2 est reliée, via un inverseur INV, à

0002247

l'entrée d'un compteur de phases d'émission CPE à cinq pas p0 à p4. Le pas 0, qui est le pas de repos, n'est pas représenté. La sortie de pas 1, p1, est reliée, d'une part, à une entrée CA de commande d'aiguillage de l'entrée EA sur la sortie SE de AIG et, d'autre part, à une bascule monostable MN1 via une diode D1. La sortie de pas 2, p2, du compteur CPE est reliée, d'une part à une bascule monostable MN2 et, d'autre part, à l'entrée de remise à zéro RZ dudit compteur via un contact de travail Ce1 d'une clé CE de commutation d'émission placée sur le pupitre PP, et via une diode D2. Un autre contact de travail ce2 de ladite clé permet de commuter l'éliminateur de rebondissements ER1 sur une bascule monostable MN3 dont la sortie est reliée à l'entrée 0 du transcodeur TC2. La sortie p3 de CPE est reliée à l'entrée CB de AIG et à l'entrée de la bascule monostable MN1 via une diode D3. La sortie p4 de pas 4 est reliée à l'entrée RZ. Les sorties des bascules MN1 et MN2 attaquent l'entrée du compteur CPE via une porte NON-OU P3. La bascule monostable MN1 effectue une temporisation de plusieurs dizaines de millisecondes avant de commander l'avance du compteur sur le pas suivant ; la temporisation de la bascule MN2 est de l'ordre de quelques millisecondes.

Dans le cas de la transmission de données, clé CE en position TRD, le dispositif fonctionne de la façon suivante. L'opérateur frappe la touche comportant le caractère qu'il veut émettre (chiffre, lettre ou signe), puis la touche TEC d'extension de code dont la couleur est identique à celle de la case de la touche sur laquelle est inscrit ledit caractère. Les numéros d'ordre décimal desdites touches actionnées sont respectivement transcodés en code 2 1/4 par les transcodeurs TC1 et TC2, puis enregistrés successivement dans les registres RG1 et RG2 lors du front montant du signal d'état 1 présenté sur leur entrée H. La frappe de la touche d'extension de code déclenche le compteur de phases d'émission CPE qui passe au pas 1, déclenche la temporisation de la bascule MN1 et, durant ladite temporisation (40 millisecondes par exemple), applique sur l'entrée CA de AIG un signal de commande d'aiguillage EA-SE de la première combinaison de fréquences codée 2 1/4 qui est ainsi transférée vers l'émetteur multifréquence EMF. En fin de temporisation, MN1 commande la progression du compteur au pas 2. La clé CE étant en position TRD de transmission de données, le contact de travail Ce1 est ouvert, interdisant ainsi la remise à zéro du compteur. Dès son passage au pas 2 le compteur CPE excite la bascule monostable MN2 laquelle, trois millisecondes plus tard par exemple, délivre un signal provoquant le passage dudit compteur au pas 3. Le signal en sortie p3 de CPE déclenche la temporisation de MN1 et commande, par l'entrée CB de AIG, l'aiguillage EB-SE et le transfert sur EMF de la seconde combinaison codée 2 1/4 de fréquences. Quarante millisecondes plus tard, MN1 commande le passage du compteur CPE sur le pas 4 et le signal en sortie p4 commande la remise à zéro dudit compteur. On effectue ainsi l'émission successive en ligne des deux paires de fréquences dues respectivement à la frappe successive d'une touche TCL et d'une touche TEC.

Lorsque l'opérateur veut utiliser son pupitre pour effectuer une numérotation téléphonique classique, il oriente la clé CE en position NUT, laquelle ferme les contacts Ce1 et Ce2. Le contact Ce2 met en jeu la bascule monostable MN3 qui, après une temporisation de son circuit d'entrée TB3, délivre une impulsion sur l'entrée 0 du transcodeur TC2. Cette impulsion simule la frappe de la touche TE0 et permet ainsi l'avancement du compteur CPE au pas 1. La combinaison codée 2 1/4 provenant de la touche TCL est transmise en ligne comme précédemment, puis, comme le contact Ce1 est établi, le compteur CPE revient à zéro dès son passage au pas 2. Le circuit d'entrée retardateur TB2 interdit le basculement de la monostable MN2 durant la transition pas 2-pas 0 du compteur. Seule la combinaison du code de base est ainsi transmise en ligne et l'autocommutateur téléphonique l'interprète comme provenant d'une numérotation multifréquence frappée au clavier d'un poste téléphonique.

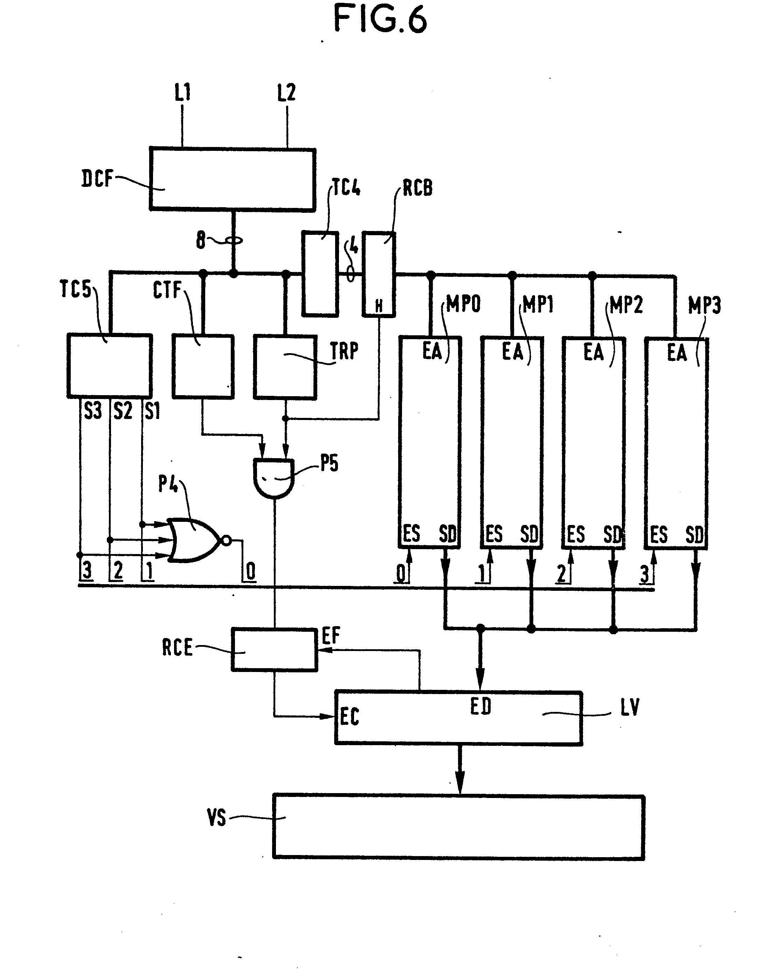

Le dispositif de réception représenté figure 6 comporte en dérivation sur la ligne L1-L2 un détecteur-codeur de fréquences DCF à huit sorties, lequel marque durant chaque réception de combinaisons multifréquences deux des huit sorties correspondant aux fréquences détectées. Les sorties du détecteur-codeur DCF sont reliées en parallèle à un transcodeur 2/8 - binaire TC4 des

0002247

signaux du code de base, à un transcodeur 2/8 -décimal TC5 des signaux d'extension de code, à un dispositif de contrôle CTF de la réception de deux fréquences parmi deux groupes de quatre fréquences, à raison d'une fréquence par groupe, et à un dispositif de temporisation de reconnaissance TPR. La sortie quatre fils du transcodeur TC4 est reliée, via un registre RCB, en parallèle aux entrées d'adresse EA de quatre mémoires programmables MP0 à MP3. L'entrée H d'horloge du registre RCB est reliée à la sortie du dispositif de temporisation TPR. Les sorties S1 à S3 du transcodeur TC5 désignent les combinaisons d'extension E2 à E4 et sont reliées respectivement aux entrées de sélection ES des mémoires MP1 à MP3. La combinaison E1 est décodée via les sorties S1 à S3 et une porte NON-OU P4 dont la sortie est reliée à l'entrée ES de la mémoire MP0. Les sorties de données SD des mémoires MP sont reliées en parallèle aux entrées de données ED d'une logique de visualisation LV associée à une visualisation VS à décalage, du type calculatrice. Les sorties des dispositifs CTF et TPR commandent, via une porte ET P5 et un registre tampon RCE, l'entrée d'échantillonnage EC de la logique LV. La logique LV assure l'effacement du registre RCE lorsqu'elle a enregistré les données provenant d'une mémoire lue.

Dans les deux formes de réalisation décrites ci-dessus, les mémoires MP1 à MP4 (fig. 3) respectivement, mémoires MP0 à MP3 (fig. 6) sont programmées de façon à contenir chacune une partie des caractères du tableau 2, une colonne E1 à E4 dudit tableau étant affectée à chacune desdites mémoires. La réception de la première combinaison de fréquences (code 2 1/4) permet ainsi d'adresser un niveau des mémoires correspondant à une rangée du tableau 2 désignée par ladite combinaison. La réception de la seconde combinaison de fréquences (extension de code) permet de sélectionner l'une des mémoires dont le rang correspond au numéro de colonne dudit tableau. On extrait ainsi de ladite mémoire un caractère identique à celui présenté à titre d'exemple selon les coordonnées du tableau 2.

Chaque mémoire peut comporter plusieurs groupes de voies de sortie allant vers des unités de traitement de types

0002247

différents, tels que visualisation, imprimante, bande magnétique, etc.. Un même caractère est alors programmé sur une même ligne de mémoire selon plusieurs langages codés tels que, par exemple, ASCII, COBOL, FORTRAN, chacun desdits langages étant approprié à l'unité de traitement destinataire.

REVENDICATIONS

1. Dispositif de transmission de caractères applicable à un terminal téléphonique à clavier du type à code multifréquence, ledit dispositif comportant un circuit d'émission (figure 2) et un circuit de réception (figure 3) des signaux du code multifréquence, un dispositif d'affichage (VS) des caractères utilisables en émission et en réception, et des moyens d'extension de code permettant d'associer à chaque touche plusieurs caractères, le circuit d'émission émettant un signal multifréquence de code de base sélectionné par l'actionnement d'une touche (TCL) du clavier et un signal multifréquence sélectionné à l'aide des moyens d'extension de code, caractérisé par le fait que ledit circuit d'émission comporte des premiers moyens d'enregistrement (RG1) et de codage (TC1) du numéro d'identification du signal du code de base correspondant à la touche actionnée, des seconds moyens d'enregistrement (RG2) et de codage (CEC) du numéro d'identification du signal d'extension de code, un émetteur multifréquence (EMF) relié à la ligne téléphonique, un aiguilleur (AGE, AIG) dont les entrées (EA, EB) sont reliées à la sortie des premiers et des seconds moyens d'enregistrement et de codage, et un circuit séquentiel (CPE) de commande de l'aiguilleur, et en ce que ledit circuit de réception comporte un circuit de détection et de codage (CDF) de signaux multifréquences reliés à la ligne téléphonique, une mémoire (MP1 à MP4, MP0 à MP3) contenant tous les caractères utilisés par le dispositif de transmission, la sortie (SD) de la mémoire étant reliée au dispositif d'affichage (VS) des caractères, des moyens d'enregistrement (RCB) contrôlés par un circuit de temporisation (TPR) et reliés à la sortie du circuit de détection et de codage (CDF) pour mémoriser successivement le numéro d'identification du signal du code de base et le numéro d'identification du signal d'extension de code, lesdits numéros d'identification étant combinés pour permettre l'adressage de ladite mémoire.

0002247

2. Dispositif de transmission de caractères suivant la revendication 1, caractérisé par le fait qu'il comporte un premier groupe de touches (TCL) pour commander l'émission des signaux multifréquences du code de base, et un second groupe de touches (TEC) pour commander les signaux d'extension de code, chacune des touches du premier groupe comportant autant de caractères qu'il y a de touches dans le second groupe, et chacun des caractères comportant un moyen de repérage de la touche du second groupe à utiliser.

3. Dispositif suivant la revendication 2, caractérisé par le fait que les signaux multifréquences du code de base et les signaux multifréquences d'extension de code sont constitués chacun par une combinaison de deux fréquences.

4. Dispositif selon la revendication 3, caractérisé par le fait que ledit circuit séquentiel comprend un compteur (CPE) dont les pas 1 et 3 sont reliés aux entrées de commande (CA, CB) d'un aiguilleur (AIG) desdits signaux codés et à une bascule monostable (MN1) à phase longue de basculement, le pas 2 dudit compteur étant relié à une bascule monostable (MN2) à phase courte de basculement, ledit compteur étant commandé par les touches d'extension de code via une première porte (P2) et par lesdites bascules monostables via une seconde porte (P3), les entrées de données (EA, EB) dudit aiguilleur étant reliées respectivement aux sorties des premier et second registres, la sortie dudit aiguilleur étant reliée à un émetteur multifréquence (EMF).

5. Dispositif suivant la revendication 1, caractérisé par le fait que le numéro d'identification de l'extension de code est émis en sortie d'un compteur piloté par une horloge, la progression du compteur étant validée par l'actionnement de l'une quelconque des touches du clavier, et provoquant le défilement sur le dispositif d'affichage (VS) des caractères correspondant à la touche actionnée, et le relâchement de la touche provoquant l'affichage permanent du dernier caractère affiché avant le relâchement.

6. Dispositif selon la revendication 1, caractérisé par le fait que, en agissant sur un moyen de réglage manuel de la période d'horloge commandant l'apparition desdits caractères sur le dispositif d'affichage, l'opérateur peut se familiariser à la manipulation du clavier en provoquant la succession des caractères visualisés, d'abord à vitesse lente, puis en augmentant progressivement ladite vitesse en fonction de la dextérité acquise.

7. Dispositif suivant la revendication 5, caractérisé par le fait que les signaux multifréquences du code de base et les signaux multifréquences d'extension de code sont constitués chacun par une combinaison de deux fréquences.

8. Dispositif suivant la revendication 7, caractérisé par le fait qu'il comporte une liaison directe entre le circuit d'émission (figure 2) et le circuit de réception (figure 3) du poste à clavier permettant de transmettre à la mémoire du dispositif de réception le numéro d'identification du signal de code de base et le numéro d'identification du signal de code d'extension enregistré dans le circuit d'émission sans passer par la liaison émetteur-récepteur multifréquence.

9. Dispositif de transmission suivant la revendication 8, dans lequel lesdits moyens d'affichage comportent un dispositif de visualisation (VS) permettant d'afficher plusieurs chiffres, piloté par une logique de visualisation (LV) permettant de décaler les chiffres successifs affichés par le dispositif de visualisation ladite logique possédant une entrée d'inhibition de décalage permettant de substituer chaque chiffre arrivant au chiffre affiché précédemment, caractérisé par le fait que le circuit récepteur comporte un dispositif d'aiguillage d'entrée de la mémoire, donnant accès dans une première position à ladite liaison directe, et dans une seconde position à la sortie desdits moyens d'enregistrement du circuit récepteur, et en ce que ladite liaison directe comporte un fil supplémentaire relié

0002247

- 4 -

côté émetteur à l'entrée de validation de progression du compteur, et côté récepteur à l'entrée d'inhibition de décalage de la logique de visualisation et à une entrée de commande de positionnement du dispositif d'aiguillage.

# FIG.1

FIG. 2

0002247

FIG.3

3/6

0002247

0002247

# FIG.4

VS

MAG 5 ETT.5 RAY.4 ?

bl ro Ti

TEo

| : | / | B | A | E | D |
|---|---|---|---|---|---|
| ? | 1 | C | 2 | F | 3 |

ja

ve

| H | G | K | J | N | M |
|---|---|---|---|---|---|
| I | 4 | L | 5 | O | 6 |

TE1
ja

| Q | P | T | S | W | V |
|---|---|---|---|---|---|
| R | 7 | U | 8 | X | 9 |

TE2
ro

| + | = | Z | Y | • | x |
|---|---|---|---|---|---|
| − | * | ^ | 0 | , | # |

TE3
bl

CE

TRD

NUT

TEC

TCL

PP

0002247

FIG.5

0002247

# FIG.6

0002247

**Office européen des brevets**

## RAPPORT DE RECHERCHE EUROPEENNE

Numéro de la demande
EP 78 10 1468

| Catégorie | DOCUMENTS CONSIDERES COMME PERTINENTS | | CLASSEMENT DE LA DEMANDE (Int. Cl.²) |
|---|---|---|---|
| | Citation du document avec indication, en cas de besoin, des parties pertinentes | Revendication concernée | |
| | US – A – 4 012 599 (MEYER)<br>* Colonne 3, lignes 1-35; colonne 7, lignes 48-62; figure 1a * | 1,2 | H 04 M 11/06<br>H 04 L 27/30<br>G 06 F 3/02 |
| | --- | | |
| | FR – A – 2 251 864 (TERMIFLEX)<br>* Page 4, lignes 6-31; figure 1 * | 1,2 | |
| | --- | | |
| | IBM TECHNICAL DISCLOSURE BULLETIN, vol. 17, nr. 9, février 1975, New York, USA, KANEKO et al. "Kanji keyboard containing standard alphanumeric/katanaka character arrangement", page 2665<br>* Lignes 1-6; figure * | 1,2 | DOMAINES TECHNIQUES RECHERCHES (Int. Cl.²)<br><br>G 06 F 3/02<br>H 04 M 11/06<br>H 04 L 17/04<br>27/26<br>27/28<br>27/30<br>B 41 J 5/28 |
| | --- | | |
| | IBM TECHNICAL DISCLOSURE BULLETIN, vol. 15, nr. 5, octobre 1972, New York, USA, ALTMAN "Character display and input device", page 1619<br>* Totalité * | 5 | |
| | --- | | |
| | US – A – 3 771 156 (WATTS)<br>* Résumé; colonne 3, ligne 19 à colonne 4, ligne 64; figures 1, 2A-2L * | 5,6 | CATEGORIE DES DOCUMENTS CITES<br><br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons |
| | --- | | |
| A | FR – A – 2 239 926 (DAMLAMIAN)<br>* Page 3, lignes 25-33; revendication 6; figure 5a * | 1 | |
| | ----- | | &: membre de la même famille, document correspondant |

Le présent rapport de recherche a été établi pour toutes les revendications

| Lieu de la recherche | Date d'achèvement de la recherche | Examinateur |
|---|---|---|
| La Haye | 05-02-1979 | WANZEELE |

OEB Form 1503.1  06.78